Europäisches Patentamt

European Patent Office

Office européen des brevets

(19)

(11) Numéro de publication: **0 043 778**
**A1**

## DEMANDE DE BREVET EUROPEEN

(12)

(21) Numéro de dépôt: **81401101.1**

(22) Date de dépôt: **08.07.81**

(51) Int. Cl.³: **H 01 R 43/02**

(30) Priorité: **09.07.80 FR 8015232**

(43) Date de publication de la demande: **13.01.82**
**Bulletin 82/2**

(84) Etats contractants désignés: **AT BE CH DE FR GB IT LI LU NL SE**

(71) Demandeur: **Gleizes, Raymond Marc Xavier, 29 bis rue de Soisy, F-95600 Eaubonne (FR)**
Demandeur: **Gueritaud, Jean Yves, 7 Allée Colette, F-87100 Limoges (FR)**

(72) Inventeur: **Gleizes, Raymond Marc Xavier, 29 bis rue de Soisy, F-95600 Eaubonne (FR)**
Inventeur: **Gueritaud, Jean Yves, 7 Allée Colette, F-87100 Limoges (FR)**

(74) Mandataire: **Arnaud, Jean, 94 rue Saint Lazare, F-75009 Paris (FR)**

(54) **Procédé et appareil de présoudage de billes de soudure sur des pattes de connexion.**

(57)     L'invention concerne le présoudage de billes sur des pattes de connexion.

Elle se rapporte à un appareil dans lequel des billes d'un réservoir (76) pénètrent dans des cenaux (84) de guidage, ouverts ou fermés par des dispositifs de sélection, et sont introduites une à une, par un tiroir (88), dans des canaux (100) de positionnement. Des électrodes (116) viennent souder les billes des canaux (100) sur des pattes de connexion maintenues sur une contreélectrode (48).

Application au soudage des pattes de connexion des circuits électroniques portés par des substrats.

EP 0 043 778 A1

Procédé et appareil de présoudage de billes de soudure sur des pattes de connexion.

L'invention concerne la fixation de pattes de connexion sur des substrats portant des circuits électriques ou électroniques, par présoudage de billes de soudure sur ces pattes.

On sait que de nombreux circuits électriques et électroniques sont actuellement formés sur des substrats isolants, notamment céramiques, et portent des séries de pattes de connexion. Ces séries de pattes, formées à l'aide de bandes continues, comportent une ou deux rives percées de trous de pilotage et des pattes de connexion comportant une ou plusieurs griffes. Les griffes des pattes sont placées à cheval sur un bord du substrat isolant afin qu'un côté des griffes au moins soit au contact d'une partie conductrice du substrat. Les griffes sont ensuite soudées aux parties conductrices, après suppression de l'une des rives le cas échéant, afin que chaque patte de connexion soit séparée des voisines.

Le soudage des griffes des pattes de connexion est réalisé le plus souvent par soudure à la vague. Dans cette opération, une vague de soudure vient successivement au contact des différentes griffes et assure leur soudage sur les parties conductrices placées à leur contact. Cependant, ce procédé de soudage à la vague présente des inconvénients, surtout au point de vue sanitaire, car il nécessite non seulement l'utilisation de bains importants de métaux fondus, mais aussi celle de bains nocifs de flux (désoxydants).

On connaît aussi déjà un procédé de collage de petits lopins de fil de soudure sur les pattes de connexion. Ce collage présente deux inconvénients principaux, d'une part celui de ne pas être très solide et de provoquer souvent la perte du lopin de fil de soudure, et d'autre part d'introduire une matière adhésive qui perturbe la formation d'une soudure efficace, lors d'une fusion ultérieure.

L'invention concerne de façon générale la
fixation de billes de soudure sur des pattes de connexion, par réalisation d'un présoudage. Ce présoudage
présente l'avantage de ne pas introduire de matières
étrangères et de donner une bonne résistance mécanique.
Dans cette opération de présoudage, seule une très petite partie de la bille se déforme et se soude à la
griffe de la patte associée de connexion.

Selon une caractéristique avantageuse de
l'invention, les billes de soudure ne sont présoudées
que sur les pattes qui doivent effectivement être soudées au circuit porté par le substrat.

L'invention concerne ainsi un appareil qui
comporte un dispositif de support de la bande de pattes
de connexion, un ensemble destiné à présenter une bille
sur chaque patte qui doit  être effectivement soudée
afin que cette bille soit positionnée sur la patte correspondante, et un dispositif de présoudage de chaque
bille positionnée. En outre, un dispositif de commande
synchronisée assure le fonctionnement convenable de
l'appareil.

L'invention concerne aussi un procédé de présoudage de billes de soudure sur des pattes de connexion,
ce procédé comprenant le support des pattes, le positionnement sélectif de billes sur les seules pattes qui doivent être soudées à un circuit électrique, et le présoudage des billes ainsi positionnées par application d'électrodes contre les billes et par circulation d'un courant électrique.

Plus précisément, l'invention concerne un
appareil de présoudage de billes sur des pattes de
connexion d'une bande continue, cet appareil comprenant
    - un dispositif de support de la bande afin
que des pattes occupent des positions prédéterminées,
    - un ensemble de présentation de billes,
comportant une série de canaux de guidage et un dispositif de sélection destiné à permettre ou à empêcher sélectivement l'entrée de billes dans chacun des canaux de guidage,

- un dispositif de présoudage comportant des électrodes destinées à venir coopérer avec des billes positionnées par l'ensemble de présentation, et

- un dispositif de commande synchronisée de l'appareil,

le dispositif de support et l'ensemble de présentation étant mobiles l'un par rapport à l'autre entre une première position relative dans laquelle une bande de connexion peut se déplacer librement entre eux et une seconde position relative dans laquelle la bande est maintenue entre eux, et

l'ensemble de présentation et le dispositif de présoudage étant mobiles l'un par rapport à l'autre, entre une première position relative dans laquelle le dispositif de présoudage ne coopère pas avec des billes positionnées et une seconde position relative dans laquelle le dispositif de présoudage est destiné à être au contact de billes positionnées.

Selon une caractéristique avantageuse, le dispositif de sélection de l'ensemble de présentation de billes comporte des organes de sélection associés chacun à l'un des canaux de guidage et mobiles chacun entre une première position dans laquelle il empêche l'entrée de billes dans le canal associé de guidage et une seconde position dans laquelle il permet cette entrée de billes.

Chaque organe de sélection est avantageusement sous forme d'une tige mobile en rotation autour de son axe longitudinal, entre deux positions, et comporte, à une première extrémité, un dispositif dissymétrique dégageant l'entrée d'un canal associé de guidage lorsque l'organe est dans sa première position et obturant au moins en partie l'entrée du canal associé lorsque l'organe est dans sa seconde position ; cet organe comporte, à son autre extrémité, un dispositif de commande de sa tige, destiné à déplacer celle-ci entre ses deux positions au moins.

L'ensemble de présentation de billes sur les pattes comporte avantageusement

- un dispositif de rangement de billes qui comprend le dispositif de sélection,

- un dispositif de séparation de billes une à une, ayant un organe mobile de séparation, et

- un dispositif de positionnement de billes séparées sur des pattes.

Il est avantageux que le dispositif de rangement de billes de l'ensemble de présentation comporte un réservoir de billes délimité par des parois et un fond, les canaux de guidage de billes traversant le fond du réservoir, et un agitateur destiné à déplacer les billes se présentant à l'entrée des canaux afin qu'elles s'alignent dans ceux-ci sans se coincer. L'agitateur comporte avantageusement une réglette ayant un bord chanfreiné et échancré, cette réglette étant mobile longitudinalement afin que le bord chanfreiné se déplace très près du bord des canaux de guidage du fond du réservoir.

Il est en outre avantageux que le dispositif de positionnement de billes comporte un corps qui délimite une surface de glissement et une tête traversée par des canaux de positionnement.

Le dispositif de présoudage comporte avantageusement un corps conducteur de l'électricité, portant des électrodes qui, lorsque le dispositif de présoudage est dans sa seconde position relative, pénètrent dans les canaux de positionnement du dispositif de positionnement et exercent sur les billes présentes dans ces canaux des forces tendant à les appliquer contre les pattes d'une bande de connexion.

Il est aussi avantageux que le dispositif de support de bande comporte un dispositif de pilotage, comprenant par exemple au moins un pion mobile en translation dans une fourchette solidaire de l'ensemble de présentation et mobile en translation dans un trou de guidage du dispositif de support de bande.

Le dispositif de commande synchronisée assure avantageusement

- le déplacement relatif du dispositif de support et de l'ensemble de présentation,

- le déplacement relatif de l'ensemble de présentation et du dispositif de présoudage, et

- le déplacement de l'organe mobile de séparation de billes.

Dans certaines applications, il est avantageux que l'appareil comporte en outre un second ensemble de présentation et un second dispositif de présoudage, placés par rapport au dispositif de support de manière qu'ils assurent un présoudage à des emplacements différents de ceux auxquels le premier ensemble de présentation et le premier dispositif de présoudage assurent la fixation de billes de soudure.

L'invention concerne aussi un procédé de présoudage de billes de soudure, contenant un flux ou non, sur des pattes de connexion d'une bande continue, ce procédé comprenant

- le support d'un groupe de pattes de connexion de la bande continue,

- le positionnement sélectif de billes de soudure sur certaines seulement des pattes du groupe,

- l'application d'électrodes contre les billes positionnées et l'application d'une contre-électrode contre les pattes, et

- la circulation d'un courant électriqe entre les électrodes et la contre-électrode afin que chaque bille positionnée soit présoudée sur la patte correspondante de connexion.

Les billes utilisées pour le présoudage peuvent être du type à flux incorporé ou du type sans flux, par exemple.

D'autres caractéristiques et avantages de l'invention ressortiront mieux de la description qui va suivre, faite en référence aux dessins annexés sur lesquels :

- la figure 1 est une vue en plan d'une bande continue de pattes de connexion de forme connue, d'un type qui peut être fixé sur un substrat céramique après présoudage de billes de soudure dans l'appareil selon l'invention ;

- la figure 2 est une élévation latérale représentant une patte de connexion portant une bille présoudée de soudure, placée sur un substrat céramique ;

- la figure 3 est analogue à la figure 2 mais représente l'ensemble obtenu après une opération de fusion de la bille de soudure ;

- la figure 4 est une perspective représentant une patte de connexion portant une bille de soudure appliquée selon l'invention, mais distante du substrat ;

- la figure 5 est une élévation latérale avec des parties arrachées d'un appareil de présoudage de billes selon l'invention ;

- la figure 6 est une vue en plan de l'appareil de la figure 5 ;

- la figure 7 est une coupe plus détaillée d'une partie du dispositif de support, de l'ensemble de présentation, et d'une partie du dispositif de présoudage de l'appareil des figures 5 et 6 ;

- la figure 8 est une perspective avec des parties arrachées représentant une partie de l'agitateur et des canaux de guidage de billes ;

- la figure 9 est une perspective partielle représentant les organes de sélection placés à l'intérieur du réservoir de billes, devant les canaux de guidage dans l'appareil selon l'invention ;

- les figures 10, 11 et 12 sont des coupes schématiques analogues à la figure 7 mais à plus petite échelle, permettant la description du fonctionnement de l'appareil ; et

- les figures 13 et 14 sont respectivement une vue en plan et une vue de bout, avec des parties arrachées, d'une variante d'appareil selon l'invention assurant deux opérations de présoudage.

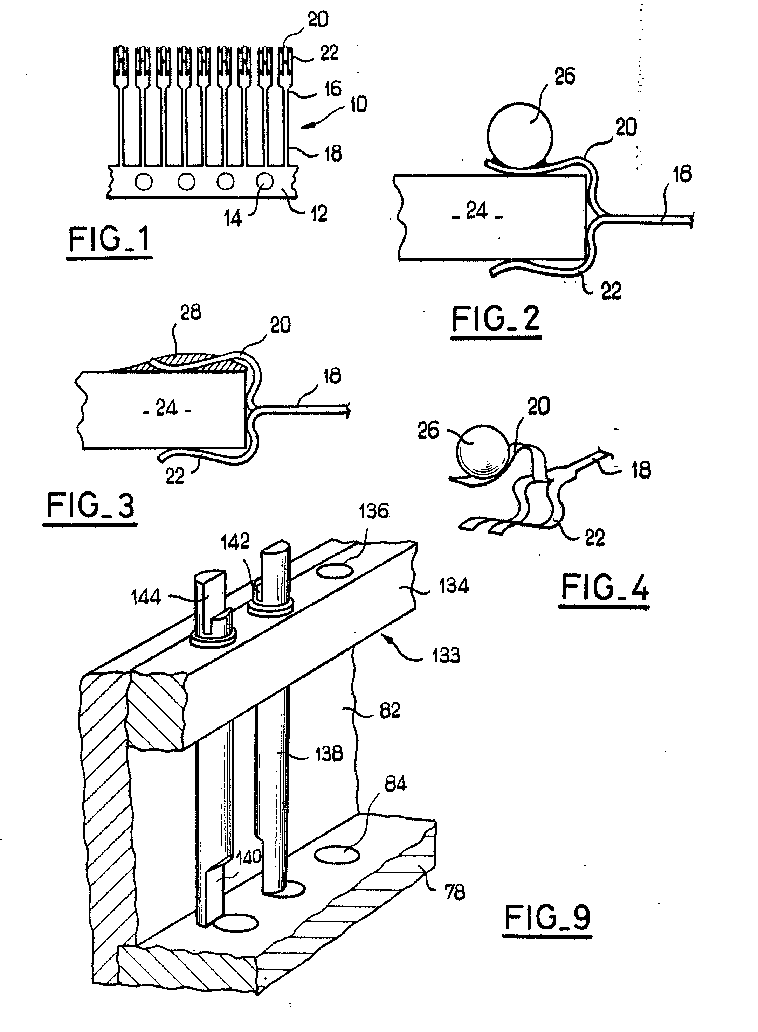

La figure 1 représente un exemple de bande continue 10 de pattes de connexion. Cette bande porte un ruban latéral continu 12, appelé "rive", percé de trous 14 de pilotage et portant d'un côté des pattes 16 de connexion. Ces pattes 16 ont une tige 18 raccordée à une extrémité à la rive 12 et, à l'autre extrémité, à des griffes 20 et 22 qui apparaissent plus clairement sur les figures 2, 3 et 4. Sur ces figures, on note qu'une griffe 20 de forme sinueuse est décalée d'un premier côté de la tige 18 alors que les deux griffes 22 sont décalées de l'autre côté de cette même tige. De cette manière, les griffes 20, 22 peuvent enfourcher un substrat 24 portant un circuit électrique ou électronique, comme indiqué sur la figure 2.

Selon les procédés connus, les bandes de pattes de connexion disponibles dans le commerce comportent des pattes équidistantes de façon continue, à intervalles prédéterminés constituant le pas. L'insertion des substrats dans les griffes des pattes est généralement effectuée par une machine dite "machine d'insertion" manuelle ou automatique. Cette machine d'insertion prépare également la bande en découpant la rive, lorsqu'elle existe dans le cas d'une bande à deux rives, car cette rive supplémentaire constituerait une continuité électrique entre les pattes ; la machine découpe aussi les pattes qui ne correspondent pas à une partie conductrice du substrat et celles qui se trouvent au raccord de deux substrats.

Le procédé et l'appareil selon l'invention sont destinés au présoudage de billes 26 sur les griffes 20. Il faut cependant noter que les billes peuvent aussi être présoudées sur les griffes 22. Il faut cependant que la griffe qui porte une bille 26 de soudure soit

0043778

celle qui est au contact d'une partie conductrice du circuit électronique porté par le substrat 24. Celui-ci est par exemple formé d'une céramique, et il porte un circuit électronique réalisé par mise en oeuvre connue de procédés d'application de couches épaisses ou minces. Des pieds métallisés, constituant des parties conductrices, sont formés sur le bord du substrat 24 et permettent la connexion des différents composants du circuit électronique à des organes externes, par l'intermédiaire des pattes de connexion.

Les billes 26 sont formées de soudure et contiennent un flux décapant. Elles sont disponibles dans le commerce et on ne les décrit pas plus en détail dans le présent mémoire.

Lorsque les billes 26 de soudure portées par une griffe telle que les griffes 20 des pattes de connexion dont les griffes enfourchent un substrat céramique 24, sont chauffées à une température supérieure à la température de fusion de leur métal constitutif, elles fondent et assurent le soudage des griffes qui les portent aux pieds métallisés du circuit électronique porté par le substrat 24. La figure 3 représente le résultat obtenu, la référence 28 désignant la soudure formée. Celle-ci est efficace parce que la bille 26 utilisée contient un flux décapant, parce qu'aucune matière étrangère ne perturbe la soudure, et parce que le volume de soudure apporté est maîtrisé par la précision de fabrication des billes.

On note donc que la fixation des billes 26 sur les griffes 20 nécessite le soudage des billes d'une manière très localisée, telle que les billes 26 conservent pratiquement leur forme et ne perdent pas le flux qu'elles contiennent.

L'invention concerne d'une part un procédé assurant le présoudage de billes 26 sur des griffes des seules pattes de connexion qui doivent être effectivement utilisées avec le circuit électronique porté par le substrat 24, et d'autre part un appareil de présoudage de telles billes.

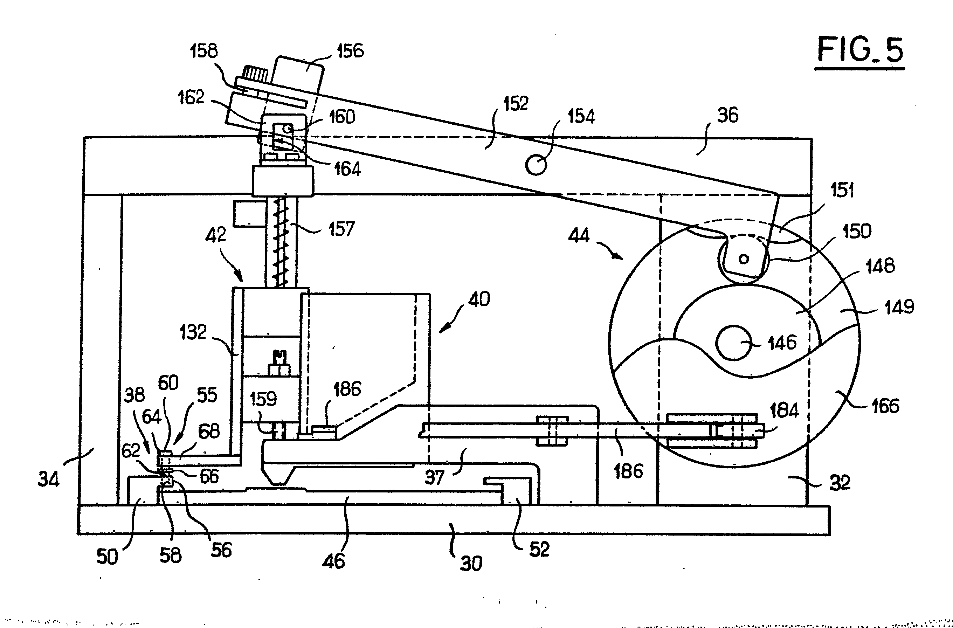

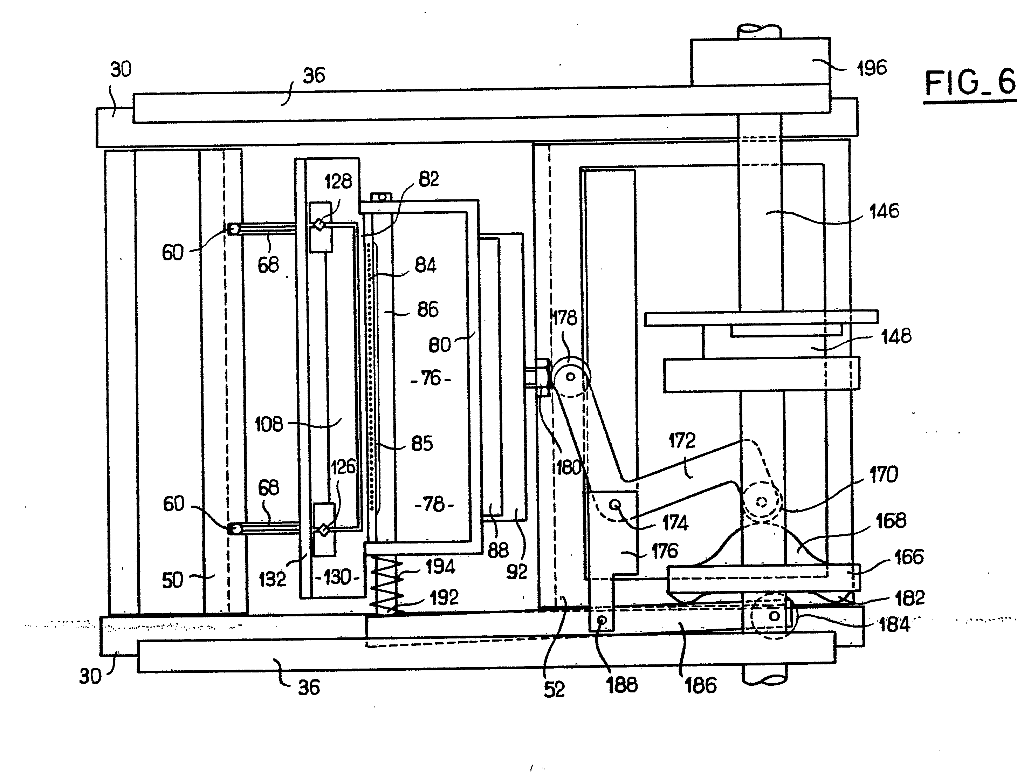

Les figures 5 et 6 représentent respectivement en élévation et en plan et sous forme schématique, un mode de réalisation d'appareil selon l'invention. Sur ces figures, certains éléments n'ont pas été représentés afin que la disposition générale des principaux organes apparaisse plus clairement.

L'appareil comporte d'abord un bâti qui peut être d'un type bien connu des spécialistes et qui comprend par exemple des organes horizontaux et longitudinaux, portant la référence 30 à la partie inférieure de la machine et la référence 36 à la partie supérieure. Les organes longitudinaux inférieurs 30 et supérieurs 36 sont reliés horizontalement par des traverses non représentées et verticalement par des colonnes avant 32 et arrière 34. Le bâti a donc une forme parallélépipédique. En outre, il comprend une plaque de support, non représentée, disposée entre les organes longitudinaux inférieurs 30 et les traverses de manière qu'elle supporte différents organes de l'appareil, et notamment un organe fixe 37.

Le bâti porte essentiellement un dispositif 38 de support, un ensemble 40 de présentation de billes, un dispositif 42 de présoudage et un dispositif 44 de commande synchronisée des différents dispositifs de l'appareil.

On considère maintenant ces différents dispositifs et ensembles les uns après les autres.

Le dispositif de support comprend essentiellement une table 46, portant une contre-électrode 48, par l'intermédiaire d'organes isolants 47, et deux glissières 50 et 52. Ces deux glissières peuvent être rapprochées ou éloignées l'une de l'autre à l'aide de volants de commande placés à l'avant de l'appareil mais qu'on n'a pas représentés. Il s'agit en effet d'une caractéristique bien connue des hommes du métier et qui existe dans de nombreux appareils. On ne la décrit pas plus en détail dans le présent mémoire. Ainsi, les deux glissières 50 et 52 peuvent être déplacées à volonté afin qu'elles guident la bande continue et le substrat au cours du fonctionnement décrit dans la suite. Lors des opérations de présoudage, les griffes des pattes sont portées par la face supérieure 54 de la contre-électrode 48.

On considère maintenant un dispositif 55 de pilotage. Le flasque 56 de la glissière avant 50 a, sur sa longueur, deux trous 58 destinés au guidage de pions 60 de pilotage. Chaque pion 60 comporte une tige 62 et deux collerettes 64 et 66. La partie de la tige 62 qui est comprise entre les deux collerettes se loge entre les bras d'une fourchette 68, solidaire de l'ensemble 40 de présentation. De cette manière, lorsque l'ensemble 40 se déplace en direction verticale, il entraîne la fourchette 68 qui appuie sur la collerette 66 ou sur la collerette 64 et permet ainsi le déplacement vertical du pion 60.

Dans une variante, le pion peut ne comporter que la collerette supérieure 64, et un ressort de rappel fixé sur la fourchette repousse le pion vers le bas de la figure 5.

L'extrémité inférieure du pion a une forme tronconique et elle est destinée à pénétrer dans un trou 14 de pilotage de la bande continue, afin que celle-ci soit maintenue lors des opérations de présoudage.

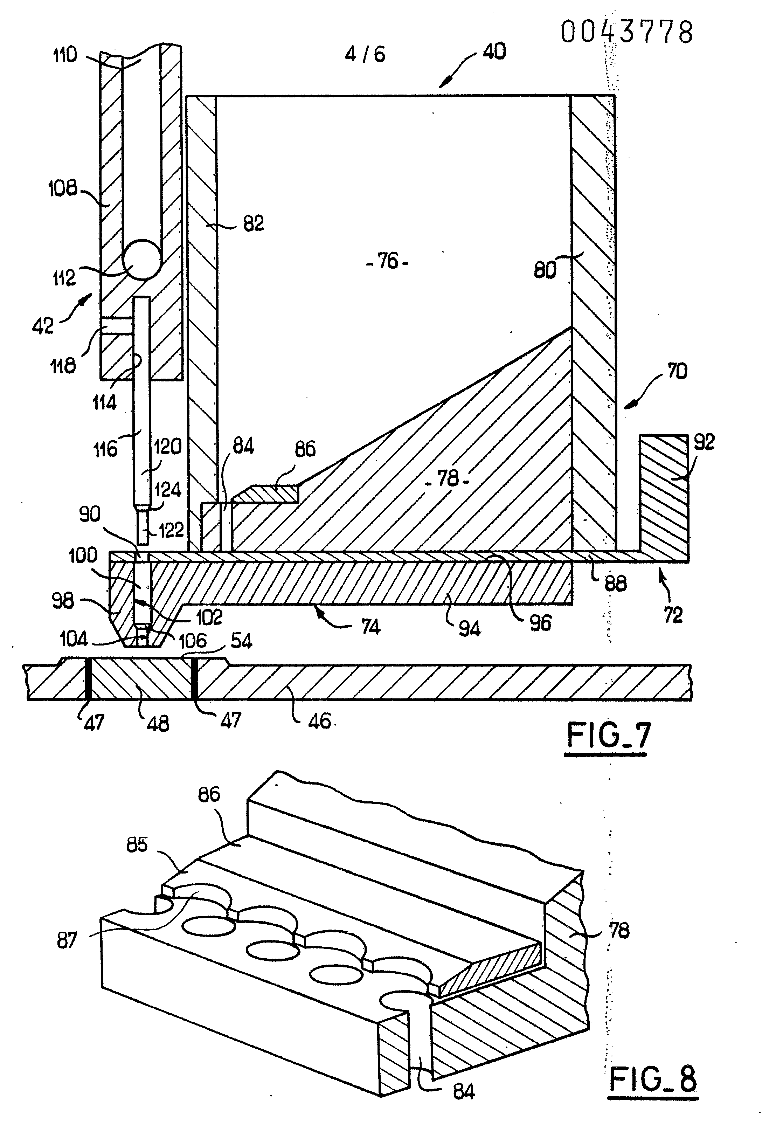

L'ensemble 40 de présentation est représenté plus en détail sur la figure 7, en coupe par un plan transversal de l'appareil (c'est-à-dire un plan perpendiculaire à la direction de déplacement de la bande et des substrats). L'ensemble 40 peut s'abaisser légè-rement par pivotement par rapport à l'organe fixe 37 du bâti. Il comprend essentiellement un dispositif 70 de rangement de billes, un dispositif 72 de séparation de billes, et un dispositif 74 de positionnement de billes séparées sur des pattes de connexion. Le dispositif 70 de rangement de billes forme essentiellement un réservoir 76 destiné à contenir des billes de soudure qui sont soigneusement calibrées. Le diamètre de ces billes est par exemple de 1,3 mm, et il ne varie pas de plus de quelques centièmes de millimètre d'une bille à l'autre.

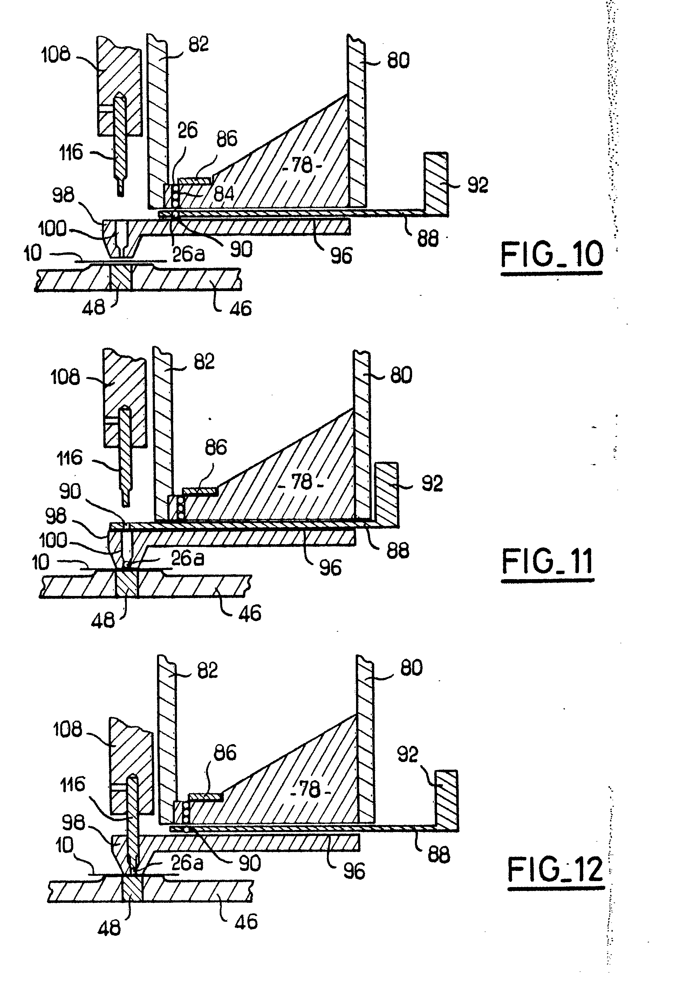

Le réservoir est délimité par un fond incliné 78, une paroi avant 80, une paroi arrière 82 et des parois latérales. Des canaux 84 de guidage traversent le fond 78 dans sa partie la plus proche de la paroi arrière 82. Ces canaux sont avantageusement suffisamment proches de la face interne de la paroi 82 pour que les billes ne puissent pas rester au repos entre cette paroi et un canal de guidage. En outre, le fond 78 du réservoir guide une réglette 86 qui, comme indiqué sur la figure 6, débouche par les deux parois latérales du réservoir 76. Le bord 85 de la réglette 86 qui est tourné vers les canaux 84 de guidage est chanfreiné et échancré, car il comporte des échancrures 87 de forme partiellement circulaire, de diamètre correspondant sensiblement à celui des canaux 84 de guidage. Lorsque la réglette 86 se déplace parallèlement à sa longueur, sous la commande d'un dispositif approprié, décrit dans la suite du présent mémoire, le bord échancré se déplace au ras du bord des canaux de guidage et empêche ainsi le coincement de billes 26 au-dessus de ces canaux. De cette manière, un certain nombre de billes s'aligne convenablement dans chaque canal 84 ouvert. La longueur de chaque canal 84 correspond avantageusement à un multiple entier du diamètre des billes. L'ouverture et la fermeture sélectives des canaux 84 sont décrites dans la suite du présent mémoire, en référence à la figure 9.

Le dispositif 72 de séparation des billes une à une comporte une plaque 88 formant tiroir, percée de trous 90 de logement de billes. La plaque 88 a avantageusement une épaisseur égale au diamètre des billes si bien que, lorsque le trou 90 se trouve sous un canal 84 de guidage, une bille de ce canal tombe dans le trou 90. Ensuite, lorsque le tiroir 88 est déplacé par application d'une force à une barre 92 d'appui formée à l'extrémité du tiroir, la plaque 88 entraîne les billes qui ont pénétré dans les trous 90.

Le dispositif 74 de positionnement de billes sur des pattes comporte un corps 94, avantageusement isolant, ayant une face supérieure 96 sur laquelle le tiroir 88 peut glisser, parallèlement au plan de la figure. Le corps 94 se termine par une tête 98 percée par des canaux 100 de positionnement. Le tiroir 88 peut prendre une position dans laquelle les trous 90 de logement se trouvent au-dessus des canaux 100 de positionnement si bien que les billes placées dans ces trous 90 dont le diamètre est légèrement supérieur à celui d'une bille, tombent dans les canaux 100.

Les canaux 100 de positionnement ont une première partie cylindrique 102 de diamètre nettement supérieur à celui d'une bille si bien qu'une bille qui tombe hors du trou 90 du tiroir 88 pénètre sans difficulté. La partie cylindrique 102 se raccorde à une partie cylindrique inférieure 104 de diamètre légèrement supérieur à celui des billes, par une partie tronconique 106. Ainsi, une bille provenant d'un trou 90 du tiroir tombe librement dans la partie cylindrique 102 puis est guidée par la partie tronconique 106 vers la partie 104 de plus petit diamètre. Une bille est ainsi présentée à l'orifice inférieur de la partie 104 du canal 100 de positionnement.

On considère maintenant le dispositif 42 de présoudage proprement dit. Celui-ci comprend une plaque massive 108, conductrice de l'électricité, percée de canaux 110, 112 de circulation d'un fluide de refroidissement tel que de l'eau. La plaque 108 est percée, à sa partie inférieure, d'une série de trous 114, en nombre correspondant au nombre de canaux 100 de positionnement. L'appareil comprend ainsi un même nombre d'électrodes 116, de canaux 100 de positionnement,de trous 90 de logement et de canaux 84 de guidage.

Les électrodes 116 sont maintenues, chacune dans son trou 114 de logement, par une vis d'arrêt vissée dans un trou taraudé 118. Chaque électrode a une partie cylindrique supérieure 120 de diamètre nettement supérieur à celui d'une bille mais inférieur à l'espacement des canaux 100 de positionnement (et donc à l'espacement des pattes de connexion de la bande continue), une partie cylindrique 122 d'extrémité de diamètre inférieur ou égal à celui d'une bille, et une partie tronconique 124 de raccordement. Le diamètre de la partie 120 d'électrode est inférieur à celui de la partie 102 du canal associé de positionnement, et le diamètre de la partie 122 est inférieur à celui de la partie 104 du canal de positionnement afin que la partie 122 puisse pénétrer dans la partie 104 du canal de positionnement et que la partie 120 de l'électrode puisse pénétrer dans la partie 102 du canal de positionnement. La longueur de la partie cylindrique 104 du canal de positionnement et celle de la partie 122 de l'électrode 116 sont choisies de manière que l'extrémité de l'électrode puisse prendre appui contre une bille placée à la partie inférieure du canal de positionnement sans que les parties tronconiques 106 du canal de positionnement et 124 de l'électrode viennent en contact. Les surfaces des canaux de positionnement, avec lesquelles les électrodes 116 peuvent être en contact, sont avantageusement formées d'une matière isolante.

La plaque conductrice 108 est montée sur des glissières 126, 128 qui permettent son coulissement par rapport à un organe 130 qui est solidaire de l'ensemble de présentation et qui forme même, dans le mode de réalisation considéré, la paroi arrière 82 du réservoir 76. De cette manière, la plaque 108 et en conséquence les électrodes 116 peuvent se déplacer verticalement par rapport à l'ensemble de présentation tout en étant guidées par rapport à celui-ci alors que le tiroir 88 peut se déplacer horizontalement dans l'ensemble de présentation.

La face avant de l'organe 130 porte une plaque 132 sur laquelle sont fixées les fourchettes 68 de guidage des pions de pilotage, comme décrit précédemment.

Avant la description du dispositif de commande synchronisée de l'appareil, on considère le dispositif 133 de sélection. Celui-ci n'est pas représenté ailleurs que sur la figure 9 afin que les dessins restent clairs. La figure 9 représente une partie du fond 70 du réservoir 76 et les ouvertures de trois canaux 84 de guidage. Elle représente en outre une partie de la paroi arrière 82 du réservoir. Une barre 134 est fixée à la paroi arrière 82 et comporte des trous 136. Des organes 138 de sélection sont associés chacun à un canal 84 de guidage. Chaque organe 138 est constitué d'une tige.L'extrémité inférieure est fraisée jusqu'au plan diamétral comme indiqué par la référence 140 afin que, suivant la position de l'organe 138 en rotation, la partie fraisée 140 permette l'entrée libre de billes dans le canal 84 associé, comme représenté pour l'organe 138 de gauche sur la figure 9, ou que la partie non fraisée de l'organe empêche la pénétration des billes dans le canal associé 84 comme représenté pour l'organe de droite de la figure 9. Les différents organes 138 peuvent être tournés afin qu'ils prennent l'une ou l'autre des deux positions indiquées, grâce à la fente 142 qui permet l'introduction d'une lame de tournevis et constitue ainsi un dispositif de commande de la tige de l'organe 138. En outre, la partie supérieure de chaque organe 138 est avantageusement fraisée de manière qu'une surface plane 144 puisse être peinte de couleur caractéristique et indique sans ambiguïté la position de l'organe 138 correspondant.

En outre, une languette non représentée est introduite dans toutes les fentes 142 des organes 138, lorsque ceux-ci ont été réglés, afin que ces organes ne puissent pas tourner dans le trou associé 136 lors du fonctionnement de l'appareil. Cette languette constitue donc un organe de verrouillage des organes 138 de sélection.

Dans une variante, la barre 134 peut comporter des encoches en V logeant les tiges qui sont repoussées dans les encoches par une plaque métallique, par l'intermédiaire d'une feuille de caoutchouc. Ce dispositif permet ainsi le blocage des tiges en position.

On considère maintenant le dispositif de commande synchronisée de l'appareil. Les différents mouvements effectués dans celui-ci sont les suivants. On suppose d'abord que l'avance de l'ensemble formé par la bande continue et le substrat céramique est assurée par un dispositif extérieur à l'appareil, par exemple par une machine d'insertion de substrats placée à proximité. Dans l'appareil lui-même, l'ensemble 40 de présentation se déplace verticalement, par pivotement sur l'organe 37 du bâti, entre une position dans laquelle une bande continue de pattes de connexion et les substrats associés peuvent se déplacer librement entre le dispositif de support et l'ensemble de présentation, et une seconde position dans laquelle la bande continue est maintenue à proximité de la tête du dispositif de positionnement. Le tiroir 88 de l'ensemble de présentation avance et recule afin que les trous 90 de logement viennent alternativement en face des canaux 84 de guidage et des canaux 100 de positionnement. Le dispositif de présoudage s'abaisse pour souder les billes et se relève. Enfin, l'agitateur se déplace longitudinalement.

Les différents mouvements précités sont commandés de la manière suivante. Un moteur non représenté et qui peut faire partie d'une autre machine, entraîne un arbre 146 en rotation. Cet arbre porte une première came ou came principale 148. Un galet 150 roule au contact de cette came et il est monté à une première extrémité d'un levier 152. Celui-ci est articulé sur le bâti, par un axe 154. Le galet 150 est maintenu au contact de la surface de la came principale 148. La seconde extrémité du levier 152 porte un poussoir élastique 156, disposé en direction sensiblement verticale dans un trou taraudé transversal, afin que sa position soit réglable et permette ainsi le réglage de la compression de son ressort interne qui conditionne ainsi son élasticité. Une vis 158 d'arrêt permet le blocage du poussoir 156 lorsqu'elle est serrée, par rapprochement des deux côtés d'une fente formée à l'extrémité du levier 152. Cette seconde extrémité du levier 152 porte aussi des axes horizontaux 160 passant dans des oreilles 162. Ces oreilles délimitent des orifices 164 dans lesquels sont disposés les axes 160.

Grâce au montage qu'on vient de décrire, lorsque la came 148 provoque le soulèvement de la première extrémité du levier 152, la seconde extrémité du levier s'abaisse et le poussoir 156 abaisse alors l'ensemble 40 de présentation. Celui-ci place la tête 98 du dispositif de positionnement à proximité des pattes de la bande de connexion et, lorsque le poussoir 156 continue à descendre, il bande des ressorts 157 mais n'abaisse pas davantage l'ensemble 40 de présentation qui est maintenu dans sa position par deux butées 159.

Pendant cette descente de l'ensemble 40 de présentation, avec le dispositif de présoudage, les axes 160 se déplacent légèrement dans les orifices 164 des oreilles 162 mais ils n'appliquent pas de force au dispositif de présoudage. Sous la pression du poussoir 156, le dispositif 42 de présoudage continue alors à descendre en étant guidé par les glissières 126 et 128. Lorsque les extrémités 122 des électrodes 116 viennent au contact des billes 26, elles-mêmes en appui contre les griffes 20 des pattes de connexion de la bande, à l'orifice inférieur des parties 104 des canaux 100, le dispositif 42 de présoudage s'immobilise dès que la pression préréglée à l'aide du poussoir 156 est atteinte.

Les dispositifs de rappel à ressorts 157 assurent ensuite le soulèvement du dispositif 42 de présoudage par rapport à l'ensemble de présentation, lorsque la came 148 permet l'abaissement de la première extrémité du levier 152 et ainsi le soulèvement de la seconde extrémité de ce levier. Lorsque cette seconde extrémité continue à se soulever parce que le galet 150 est abaissé par une contre-came 151 portée par un disque 149 solidaire de la came 148, les axes 160 de la seconde extrémité du levier continuent à se soulever et soulèvent l'ensemble 40 de présentation, en même temps que le dispositif 42 de présoudage. L'ensemble 40 de présentation s'écarte ainsi de la bande dont les pattes portent les billes présoudées.

Le dispositif de commande synchronisée comporte en outre une seconde came 166. Celle-ci porte, sur le côté, une saillie 168 qui délimite une surface de came. Un galet 170 est destiné à rouler le long de cette surface de came et il est monté à une première extrémité d'un levier coudé 172. Ce dernier est articulé sur un axe 174 fixé à un organe 176 du bâti. La seconde extrémité du levier coudé 172 porte un galet 178. Celui-ci est en appui contre une vis 180 qui est vissée dans la barre 92 d'appui du tiroir. La rotation de la vis 180 qui peut être bloquée par un contre-écrou non représenté, permet le réglage de la position du tiroir. Celui-ci est rappelé élastiquement vers la droite sur la figure 6, par un dispositif non représenté, faisant ainsi tourner le levier 172 dans le sens qui assure le contact du galet 170 et de la surface de came 168.

Ainsi, lors de la rotation de la came 166, le galet 170 se déplace longitudinalement par rapport à l'appareil et provoque alors un déplacement sensiblement transversal du galet 178. Celui-ci repousse donc le tiroir vers l'avant ou le laisse revenir vers l'arrière. Comme la came 166 est bloquée sur le même arbre que la came 148, les deux cames sont parfaitement synchronisées et les déplacements du tiroir 88 sont donc parfaitement synchronisés sur ceux de l'ensemble de présentation et du dispositif de présoudage.

L'autre face de la came 166 porte des saillies 182 délimitant une surface de came. Un galet 184 se déplace près du bord de la came 166 et les saillies 182 l'écartent de celle-ci. Le galet 184 est monté à une extrémité d'un levier droit 186 qui est articulé sur un axe 188. Ce dernier est porté par l'organe 176 du bâti et il est donc fixe. En conséquence, lorsque le galet s'écarte de la came 166 vers l'extérieur, l'autre extrémité repousse la réglette 86 de l'agitateur du dispositif de rangement de billes, en comprimant un ressort 194 de rappel. Après le passage des saillies 182 de la came 166 au-delà du galet 184, le ressort 194 repousse le levier 186. La came 166 porte de préférence trois saillies 182 de commande de l'agitateur pour une saillie 168 de commande du tiroir afin que l'agitateur se déplace trois fois à chaque cycle.

L'arbre 146 est porté par des paliers 196 dont un seul est représenté, et il est entraîné par un appareillage adéquat non représenté.

On décrit maintenant plus en détail le fonctionnement de l'appareil en référence aux figures 10 à 12. La référence 10 désigne une bande continue représentée schématiquement, éventuellement associée à un substrat céramique. Dans une première étape correspondant à la figure 10, la bande 10 a avancé en position convenable sur la table 46 et les griffes se trouvent sur la contre-électrode 48. La tête 98 du dispositif de positionnement est à une certaine distance au-dessus de la bande 10. Le tiroir 88 se trouve dans sa position extrême droite sur la figure 10, dans laquelle la bille inférieure du canal 84 de guidage du réservoir 76 vient de tomber dans le trou 90, cette bille étant repérée par la référence 26a. L'agitateur 86 se déplace longitudinalement et assure la présence de billes 26 dans chaque canal 84 de guidage dont l'organe de sélection assure l'ouverture. Le levier 152 commande alors l'abaissement de l'ensemble de présentation qui comprend le réservoir, le tiroir et le dispositif de positionnement, et simultanément celui du dispositif de présoudage. Cette étape est représentée sur la figure 11 sur laquelle on note que la tête 98 du dispositif de positionnement est venue à proximité de la bande 10. Pendant ce mouvement de descente, le tiroir 88 s'est déplacé vers la gauche et, lorsque la tête 98 vient à sa place près de la bande 10 (figure 11), le trou 90 de logement arrive en face du canal 100 de positionnement et laisse tomber la bille 26a. Celle-ci, guidée dans le canal 100 de positionnement, vient contre la griffe supérieure placée en regard du canal 100.

Dans l'étape suivante correspondant à la figure 12, le tiroir 88 revient vers la droite afin que les trous 90 prélèvent de nouvelles billes. Dès que le tiroir 88 s'est écarté, le dispositif de présoudage, représenté par la plaque conductrice 108, s'abaisse et fait pénétrer les électrodes 116 dans les canaux 100 de positionnement. Les extrémités inférieures des électrodes 116 viennent en appui contre les billes 26a et exercent une force constituant la "pression de soudage" réglée par le poussoir élastique 156. Si une bille se coince pour une raison quelconque dans le canal associé de positionnement, l'électrode la fait progresser sans difficulté dans ce canal. Dès que la force correspondant à la pression de soudage est appliquée, un courant électrique est commandé par un contacteur et circule entre la plaque conductrice 108 et la contre-électrode 48 si bien que la résistance électrique présentée à la surface de contact de la griffe et de la bille provoque une fusion partielle de cette dernière et son présoudage sur la griffe.

Ensuite, le dispositif de présoudage et l'ensemble de présentation se relèvent et la bille 26a reste soudée sur la griffe correspondante. L'ensemble 10 peut alors progresser afin qu'un nouveau groupe de pattes de connexion vienne en position sur la contre-électrode 48.

La description qui précède indique qu'il est avantageux, pour la formation du circuit électrique entre la plaque conductrice 108 du dispositif de présoudage et la contre-électrode 48 du dispositif de support, que les canaux de positionnement soient délimités par une matière isolante, et que la contre-électrode soit isolée par des organes isolants 47 par rapport au reste de la table 46. De cette manière, les pertes électriques sont réduites et le présoudage peut être effectué de manière extrêmement fiable.

On se réfère maintenant à la figure 5 pour la description des opérations de pilotage de la bande. Lorsque la bande a avancé sous la commande d'un dispositif extérieur et lorsque les pattes sont en position sous les canaux de positionnement, l'ensemble 40 de présentation s'abaisse et, comme les fourchettes 68 sont solidaires de cet ensemble, elles s'abaissent aussi et prennent position contre la collerette 66 des pions 60 qui s'abaissent et dont l'extrémité tronconique pénètre dans les trous de pilotage de la bande. Celle-ci est donc pilotée avec précision. Lorsque l'ensemble 40 se relève, les fourchettes 68 se relèvent avec lui et, par contact avec la collerette 64, écartent les pions 60 de la bande qui peut alors avancer.

Lorsque la glissière 50 est déplacée afin que l'appareil puisse traiter des bandes de largeurs différentes, les pions 60 sont entraînés par la glissière 50 et glissent entre les deux branches de la fourchette associée 68. De cette manière, le pilotage est assuré quelles que soient les dimensions de la bande continue.

A chaque cycle complet comprenant un abaissement et un relèvement de l'ensemble 40 de présentation, l'agitateur 86 est déplacé trois fois suivant sa longueur, mais ce mouvement n'a pas à être synchronisé sur les autres mouvements des organes de l'appareil.

Bien qu'on ait décrit un mode de réalisation dans lequel la bande continue des pattes de connexion forme avec le substrat un angle plat, la machine peut aussi être réalisée pour le présoudage sur des bandes formant avec le substrat un angle quelconque et notamment un angle voisin de 90°. En outre, bien qu'on ait décrit le présoudage de billes sur des griffes de pattes déjà placées sur des substrats céramiques, il est bien entendu que le présoudage des billes peut être réalisé antérieurement à l'insertion des substrats.

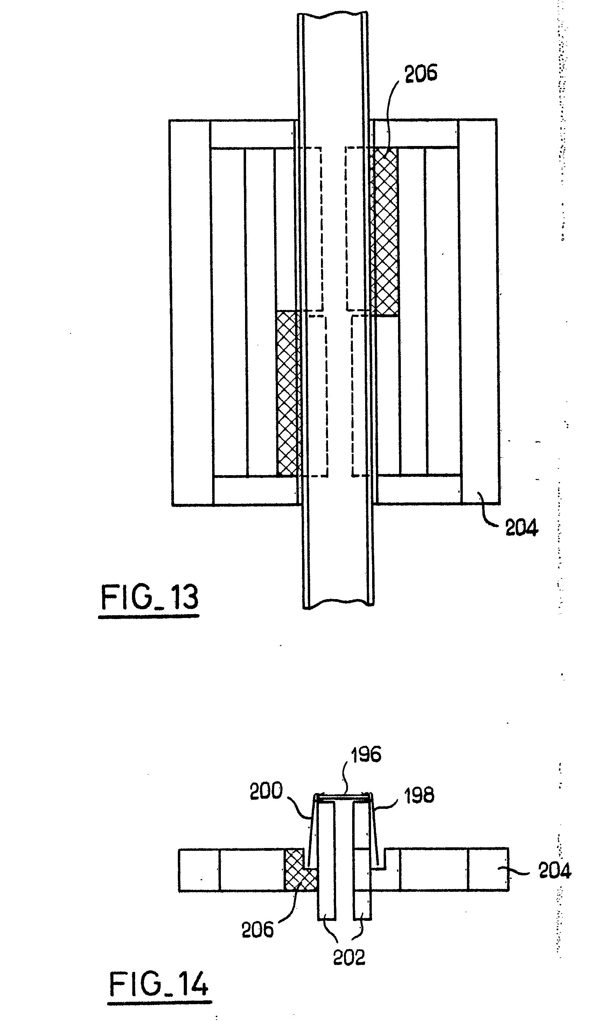

On considère maintenant, en référence aux figures 13 et 14, une variante d'appareil selon l'invention destinée à la fixation de pattes de connexion de deux côtés de substrats céramiques. Ces substrats sont repérés par la référence 196 et les deux séries de pattes de connexion 198, 200 sont représentées sous la forme dans laquelle les pattes sont repliées à près de 90° par rapport aux griffes. Le substrat et les griffes sont guidés par deux supports verticaux 202 d'écartement réglable et solidaires d'un dispositif 204 de support. Celui-ci comporte, de part et d'autre et décalés dans la direction de déplacement des substrats 196, deux organes isolants 206. Deux dispositifs de présoudage, montés sur deux ensembles de présentation, non représentés mais analogues à ceux qu'on a décrits en référence au mode de réalisation précédent, assurent le présoudage de billes sur la face supérieure des griffes des pattes 198 et 200. La figure 13 indique, par les parties à hachures croisées, que les opérations de présoudage de billes sur les griffes 198 placées d'un côté du substrat 196 sont effectuées avant les opérations de présoudage sur les griffes 200 disposées de l'autre côté du substrat.

Bien entendu, les deux dispositifs de présoudage et les deux ensembles de présentation peuvent être montés différemment, les modifications peu importantes nécessaires étant évidentes pour les hommes du métier.

Il faut noter que l'appareil selon l'invention n'est pas en général utilisé seul mais est incorporé à toute une chaîne assurant la totalité des opérations de fixation des pattes de connexion sur les substrats portant les circuits électroniques. Les opérations à réaliser sont l'insertion des substrats entre les griffes des pattes, le présoudage des billes de soudure sur les griffes des pattes demeurées en place, et la fusion des billes afin qu'elles assurent le soudage de ces pattes sur les pieds métallisés des substrats. Ces différentes opérations peuvent être effectuées dans un ordre quelconque du moment que la fusion est effectuée après le présoudage et après l'insertion des substrats entre les griffes. Ainsi, le présoudage peut être effectué avant ou après l'insertion.

L'appareil décrit permet le présoudage de billes sur les pattes de connexion de circuits pouvant avoir par exemple 40 pattes de connexion sur une longueur de 101,6 mm, à une cadence de 3000 substrats à l'heure.

Il est en outre avantageux que l'appareil soit associé à un dispositif de contrôle de présoudage. Celui-ci est d'un type très simple et comporte simplement un organe qui détermine la présence des billes présoudées. Le dispositif de contrôle, lorsqu'il a déterminé l'absence d'une bille, commande alors soit l'arrêt de la machine, soit l'avertissement d'un opérateur, soit toute autre opération.

Ainsi, le procédé et l'appareil selon l'invention permettent un présoudage fiable, ferme et sûr des billes sur la totalité ou une partie seulement des pattes de connexion. La possibilité de la connexion des seules pattes qui doivent être présoudées permet des économies importantes.

L'invention s'applique évidemment à la fabrication des composants électroniques, comprenant un substrat porteur d'un circuit et une ou deux rangées de connexion. Il existe plusieurs types de composants de dimension normalisée correspondant à cette description. Cependant, l'invention n'est pas limitée à cette seule application, et elle convient en particulier au présoudage de billes de soudure sur des organes quelconques, par exemple à l'extrémité de lames de relais, opposée au contact, pour le raccordement.

Il est bien entendu que l'invention n'a été décrite et représentée qu'à titre d'exemple préférentiel et qu'on pourra apporter toute équivalence technique dans ses éléments constitutifs sans pour autant sortir de son cadre.

## REVENDICATIONS

1. Appareil de présoudage de billes sur des pattes de connexion d'une bande continue, caractérisé en ce qu'il comprend

- un dispositif (38) de support de la bande afin que des pattes occupent des positions prédéterminées,

- un ensemble (40) de présentation de billes, comportant une série de canaux (84) de guidage, cet ensemble de présentation étant destiné à permettre l'entrée de billes dans au moins certains des canaux de guidage,

- un dispositif (42) de présoudage comportant des électrodes destinées à venir coopérer avec des billes positionnées par l'ensemble (40) de présentation, et

- un dispositif (44) de commande synchronisée de l'appareil,

le dispositif (38) de support et l'ensemble (40) de présentation étant mobiles l'un par rapport à l'autre entre une première position relative dans laquelle une bande de connexion peut se déplacer librement entre eux et une seconde position relative dans laquelle l'ensemble (40) de présentation de billes est proche des pattes de connexion, et

l'ensemble (40) de présentation et le dispositif (42) de présoudage étant mobiles l'un par rapport à l'autre, entre une première position relative dans laquelle le dispositif de présoudage ne coopère pas avec des billes positionnées et une seconde position relative dans laquelle le dispositif de présoudage est destiné à être au contact des billes positionnées.

2. Appareil selon la revendication 1, caractérisé en ce que l'ensemble (40) de présentation de billes comporte un dispositif (133) de sélection qui comporte des organes (138) de sélection associés chacun à l'un des canaux (84) de guidage et mobiles chacun entre une première position dans laquelle il empêche l'entrée de billes dans le canal associé (84) de guidage et une seconde position dans laquelle il permet l'entrée de billes dans ce canal associé (84).

3.        Appareil selon la revendication 2, caractérisé en ce que chaque organe (138) de sélection est sous forme d'une tige mobile en rotation autour de son axe longitudinal entre deux positions, et comporte, à une première extrémité, un dispositif dissymétrique (140) dégageant l'entrée d'un canal associé (84) de guidage lorsque l'organe (138) est dans sa première position et obturant au moins en partie l'entrée du canal associé (84) lorsque l'organe (138) est dans sa seconde position, et, à son autre extrémité, un dispositif (142) de commande de la tige destiné au déplacement de celle-ci entre ses deux positions au moins.

4.        Appareil selon l'une quelconque des revendications 1 à 3, caractérisé en ce que l'ensemble (40) de présentation de billes sur les pattes comporte
        - un dispositif (70) de rangement de billes qui comprend le dispositif (133) de sélection,
        - un dispositif (72) de séparation de billes une à une, ayant un organe mobile (88) de séparation, et
        - un dispositif (74) de positionnement de billes séparées sur des pattes.

5.        Appareil selon l'une quelconque des revendications 1 à 4, caractérisé en ce que le dispositif (70) de rangement de billes de l'ensemble (40) de présentation comporte
        - un réservoir (76) de billes délimité par des parois et un fond, les canaux (84) de guidage de billes traversant le fond du réservoir, et
        - un agitateur (86) destiné à déplacer les billes se présentant à l'entrée des canaux afin qu'elles s'alignent dans ceux-ci sans se coincer,
    l'agitateur (86) comportant avantageusement une réglette ayant un bord (85) chanfreiné et échancré, la ré-

0043778

glette étant mobile longitudinalement afin que le bord chanfreiné (85) se déplace très près du bord des canaux (84) de guidage du fond du réservoir (76).

6.	Appareil selon l'une des revendications 4 et 5, caractérisé en ce que le dispositif (74) de positionnement de billes comporte un corps (94) délimitant une surface de glissement et une tête (98) traversée par des canaux de positionnement.

7.	Appareil selon l'une quelconque des revendications précédentes, caractérisé en ce que le dispositif (42) de présoudage comporte un corps (108) conducteur de l'électricité, portant des électrodes (116) qui, lorsque le dispositif (42) de présoudage est dans sa seconde position relative, pénètrent dans les canaux (100) de positionnement du dispositif (74) de positionnement et exercent sur les billes présentes dans ces canaux (100) des forces tendant à les appliquer contre les pattes d'une bande de connexion.

8.	Appareil selon la revendication 4, caractérisé en ce que le dispositif (44) de commande synchronisée assure

		- le déplacement relatif du dispositif (38) de support et de l'ensemble (40) de présentation,

		- le déplacement relatif de l'ensemble (40) de présentation et du dispositif (42) de présoudage, et

		- le déplacement de l'organe mobile (88) de séparation de billes.

9.	Appareil selon l'une quelconque des revendications précédentes, caractérisé en ce qu'il comporte en outre un second ensemble de présentation et un second dispositif de présoudage, disposés par rapport au dispositif (204) de support de manière que les opérations de présoudage soient effectuées à deux endroits différents et successifs dans la direction de déplacement des bandes continues de pattes de connexion.

10.	Procédé de présoudage de billes de soudure sur des pattes de connexion d'une bande continue, ca-

0043778

ractérisé en ce qu'il comprend

- le support d'un groupe de pattes de connexion de la bande continue,

- le positionnement sélectif de billes de
soudure sur certaines seulement des pattes du groupe,

- l'application d'électrodes contre les billes
positionnées et l'application d'une contre-électrode contre les pattes, et

- la circulation d'un courant électrique entre
les électrodes et la contre-électrode afin que chaque
bille positionnée soit présoudée sur la patte correspondante de connexion.

1/6

0043778

FIG_1

FIG_2

FIG_3

FIG_4

FIG_9

FIG. 5

FIG_6

0043778

FIG_7

FIG_8

FIG_10

FIG_11

FIG_12

0043778

FIG_13

206

204

FIG_14

196

200

198

204

206

202

Office européen
des brevets

**RAPPORT DE RECHERCHE EUROPEENNE**

0043778
Numéro de la demande

EP 81 40 1101

## DOCUMENTS CONSIDERES COMME PERTINENTS

| Catégorie | Citation du document avec indication, en cas de besoin, des parties pertinentes | Revendica-tion concernée |
|---|---|---|
| A | FR - A - 2 409 123 (COMATEL)<br>* page 2, lignes 22,23 *<br><br>-- | 1 |
| A | US - A - 3 886 650 (AMP)<br>* colonne 2 *<br><br>-- | 1 |
| A | US - A - 4 164 064 (J. REAVILL)<br>* colonne 1 *<br><br>-- | 1 |
| A | FR - A - 2 045 377 (FERRANTI)<br>* page 3 *<br><br>------ | 1 |

**CLASSEMENT DE LA DEMANDE (Int. Cl.³)**

H 01 R 43/02

**DOMAINES TECHNIQUES RECHERCHES (Int. Cl.³)**

H 01 R 43/02
H 05 K 3/34
B 23 K 1/20

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 31.08.1981 | MOBOUCK |

OEB Form 1503.1  06.78